# EUROPÄISCHE PATENTSCHRIFT

(11) **EP 3 583 692 B1**
(45) Veröffentlichungstag und Bekanntmachung des Hinweises auf die Patenterteilung: **07.04.2021**
(21) Anmeldenummer: 18706635.2
(22) Anmeldetag: 07.02.2018
(51) Int. Cl.: H02M 7/00, H02M 1/12, H01L 23/055, H01L 23/433, H01L 23/48, H05K 1/02, H05K 7/20

(54) **ELEKTRONISCHE ANORDNUNG MIT LEISTUNGSMODUL, LEITERPLATTE UND KÜHLKÖRPER**
ELECTRONIC ARRANGEMENT WITH POWER MODULE, WIRING BOARD AND HEAT SINK
DISPOSITIF ÉLECTRONIQUE AVEC MODULE DE PUISSANCE, CARTE DE CIRCUIT ET DISSIPATEUR THERMIQUE

(30) Priorität: 20.02.2017 DE 102017001593
(43) Veröffentlichungstag der Anmeldung: 25.12.2019
(73) Patentinhaber: SEW-EURODRIVE GmbH & Co. KG, 76646 Bruchsal (DE)
(72) Erfinder: SCHÄFER, Jens, 76676 Graben-Neudorf (DE); HAUCK, Matthias, 68723 Schwetzingen (DE)
(86) Internationale Anmeldenummer: PCT/EP2018/025033
(87) Internationale Veröffentlichungsnummer: WO 2018/149550

(56) Entgegenhaltungen:
- EP-A1- 0 634 890
- WO-A1-2016/017311
- WO-A1-2016/147492
- DE-A1-102010 023 191
- DE-A1-102015 210 587
- US-A1- 2014 231 973

## Beschreibung

Die Erfindung betrifft eine elektronische Anordnung mit Leistungsmodul, Leiterplatte und Kühlkörper.

Es ist allgemein bekannt, dass Leistungshalbleiter Wärme erzeugen, die mittels eines Kühlkörpers abführbar sind.

Aus der EP 0 634 890 A1 ist eine Packstruktur für einen Mikrowellen-Schaltkreis bekannt.

Aus der DE 10 2015 210 587 A1 ist eine Halbleitermodulanordnung bekannt.

Aus der WO 2016/147492 A1 ist ein Umrichter mit einem PI-Filter als Filter bekannt, so dass die Kondensatoren des PI-Filters über Induktivitäten verbunden sind.

Aus der WO 2016/017311 A1 ist ein Leistungswechselrichter bekannt.

Aus der DE 10 2010 023 191 A1 ist ein Leistungsmodul bekannt.

Aus der US 2014/231973 A1 ist ein Halbleiteranordnung mit elektromagnetischer Abschirmung bekannt.

Der Erfindung liegt daher die Aufgabe zugrunde, ein Leistungsmodul weiterzubilden, wobei eine Anordnung samt Leistungsmodul einfacher herstellbar sein soll.

Erfindungsgemäß wird die Aufgabe bei der nach den in Anspruch 1 angegebenen Merkmalen gelöst.

Wichtige Merkmale der Erfindung bei der elektronischen Anordnung mit Leistungsmodul, Leiterplatte und Kühlkörper sind, dass das Leistungsmodul eine metallische Bodenplatte aufweist,
wobei eine Isolationsschicht an der der Leiterplatte zugewandten Seite der Bodenplatte angeordnet ist,
wobei an der von der Bodenplatte abgewandten Seite der Isolationsschicht metallische Leiterbahnen, insbesondere aus Kupfer, angeordnet sind,
wobei Halbleiter auf den Leiterbahnen angeordnet sind auf der von der Isolationsschicht jeweils abgewandten Seite der Leiterbahnen,
wobei die Bodenplatte direkt oder mittels einer Durchkontaktierung mit einem zur Leiterplatte als Potentialausgleich fungierenden Anschlusskontakt verbindbar ist,
wobei der als Potentialausgleich fungierende Anschlusskontakt Erdpotential aufweist,
wobei das Leistungsmodul eine kapazitive Störströme kurzschließende Entstöreinheit aufweist, wobei die Entstöreinheit drei Kondensatoren aufweist,
wobei ein erster der drei Kondensatoren mit seinem ersten Pol elektrisch mit dem als Potentialausgleich fungierenden Anschlusskontakt verbunden ist und als Y-Kondensator ausgeführt ist,
wobei die beiden anderen Kondensatoren als X-Kondensatoren ausgeführt sind und in Reihe geschaltet und aus einer Gleichspannungsquelle versorgt sind,
wobei der Y-Kondensator mit seinem anderen Pol elektrisch verbunden ist mit einem Mittelabgriff der Reihenschaltung der beiden X-Kondensatoren,
wobei die Gleichspannungsquelle die Zwischenkreisspannung eines Umrichters ist,
wobei der erste Pol des Y-Kondensators mit einer Leiterbahn des Leistungsmoduls verbunden ist, welche mittels eines Bonddrahtes mit der Bodenplatte verbunden ist.

Von Vorteil ist dabei, dass ein Potentialausgleich direkt am Leistungsmodul und in einfacher Weise erreichbar und herstellbar ist. Somit ist kein separates Kabel notwendig.

Da der Potentialausgleich erfindungsgemäß integriert ist im Leistungsmodul, ist eine einfache Herstellung ermöglicht. Denn das Leistungsmodul muss nur eingefügt werden und dann die Leiterplatte samt Anschlusskontakten auf das Leistungsmodul gedrückt werden, so dass der Wärmekontakt zum Kühlkörper in einfacher Weise herstellbar ist und gleichzeitig die Potentialausgleichsverbindung.

Insbesondere ist eine Erdverbindung als Potentialausgleich mit geringstmöglicher Wegstrecke zur Störquelle, insbesondere also die als Störquelle fungierenden Halbleiterschalter des Leistungsmoduls, realisierbar und somit eine minimale Schleifenfläche und Induktivität der Potentialausgleichsverbindung, also Potentialausgleichsleitung, erreichbar.

Die Herstellung der Erdverbindung über die Bodenfläche des Moduls gegen den Kühlkörper erfolgt flächig, also niederinduktiv und sicher, da diese Verbindung zur Kühlung des Moduls vorsehbar ist. Ein schlechter oder verschlechterter Wärmeübergang zum Kühlkörper führt zu einer entsprechend hohen Spitzentemperatur im Leistungsmodul und wird daher - insbesondere mittels eines auf dem Leistungsmodul angeordneten Temperatursensors - erkennbar, so dass ein Abschalten erfolgt.

Bei einer vorteilhaften Ausgestaltung ist die Bodenplatte aus Kupfer. Von Vorteil ist dabei, dass eine effiziente Wärmeableitung erreichbar ist.

Bei einer vorteilhaften Ausgestaltung ist die Bodenplatte an einen Kühlkörper angedrückt, insbesondere mit ihrem von der Isolationsschicht abgewandten Seite. Von Vorteil ist dabei, dass eine effiziente Wärmeabfuhr erreichbar ist und gleichzeitig eine gute elektrische Verbindung, so dass auch der Kühlkörper mit der Potentialausgleichsverbindung versorgt ist.

Bei einer vorteilhaften Ausgestaltung ist der Anschlusskontakt ein Druckkontakt, ein Federkontakt, ein Lötkontakt oder ein Einpresskontakt. Von Vorteil ist dabei, dass eine einfache Herstellung erreichbar ist.

Bei einer vorteilhaften Ausgestaltung ist der Anschlusskontakt mit der Leiterplatte mechanisch und elektrisch verbunden. Von Vorteil ist dabei, dass eine einfache Herstellung erreichbar ist.

Bei einer vorteilhaften Ausgestaltung ist
der Anschlusskontakt
- an die Bodenplatte oder
- an eine Durchkontaktierung oder
- an eine auf der Isolationsschicht angeordnete Leiterbahn, welche mit einer mit der Bodenplatte elektrisch verbundenen Durchkontaktierung verbunden ist,
angedrückt gehalten. Von Vorteil ist dabei, dass eine einfache Kontaktierung ermöglicht ist.

Bei einer vorteilhaften Ausgestaltung berührt die Bodenplatte den Kühlkörper,
wobei die Berührfläche zwischen Bodenplatte und Kühlkörper eben ist, insbesondere also von einer Ebene umfasst ist,
wobei der von der senkrechten Projektion der Bodenplatte in die Ebene überdeckte Flächenbereich größer ist als der von der senkrechten Projektion der Isolationsschicht in die Ebene überdeckte Flächenbereich. Von Vorteil ist dabei, dass die Bodenplatte seitlich hervorragt und somit eine als Potentialausgleichsverbindung fungierende Kontaktierung in einfacher Weise direkt an der Bodenplatte, insbesondere an der vom Kühlkörper abgewandten Seite der Bodenplatte ausführbar ist, insbesondere an dem seitlich hervorragenden Bereich.

Bei einer vorteilhaften Ausgestaltung drückt ein an einem mit dem Kühlkörper verbundenen Gehäuseteil der Anordnung abgestütztes Federelement die Leiterplatte an das Leistungsmodul mittels der Anschlusskontakte an,
insbesondere so, dass das Leistungsmodul auf den Kühlkörper gedrückt wird. Von Vorteil ist dabei, dass eine einfache Herstellung und ein guter Wärmeübergang herstellbar ist.

Bei einer vorteilhaften Ausgestaltung ist die Isolationsschicht aus Keramik, insbesondere Korund und/oder einem Aluminiumoxid enthaltenden Stoffgemisch, gefertigt. Von Vorteil ist dabei, dass die Isolationsschicht den Zusammenhalt des Leistungsmoduls bewirkt.

Bei einer vorteilhaften Ausgestaltung ist die Leiterplatte mit Bauelementen einer Signalelektronik bestückt, welche Ansteuersignale für steuerbare Halbleiter des Leitungsmoduls erzeugt. Von Vorteil ist dabei, dass eine kompakte Anordnung ausbildbar ist.

Bei einer vorteilhaften Ausgestaltung ist die Anordnung ein Wechselrichter oder ein Umrichter, welcher einen Elektromotor speist. Von Vorteil ist dabei, dass der Wechselrichter oder Umrichter eine kompakte Anordnung aufweist zur effizienten Abfuhr von Wärme an den Kühlkörper.

Weitere Vorteile ergeben sich aus den Unteransprüchen. Die Erfindung ist nicht auf die Merkmalskombination der Ansprüche beschränkt. Für den Fachmann ergeben sich weitere sinnvolle Kombinationsmöglichkeiten von Ansprüchen und/oder einzelnen Anspruchsmerkmalen und/oder Merkmalen der Beschreibung und/oder der Figuren, insbesondere aus der Aufgabenstellung und/oder der sich durch Vergleich mit dem Stand der Technik stellenden Aufgabe.

Die Erfindung wird nun anhand von Abbildungen näher erläutert:
In der Figur 1 ist ein Querschnitt durch ein Leistungsmodul gezeigt.

In der Figur 2 ist ein Querschnitt durch ein erfindungsgemäßes Leistungsmodul gezeigt.

In der Figur 3 ist ein Querschnitt durch ein anderes erfindungsgemäßes Leistungsmodul gezeigt.

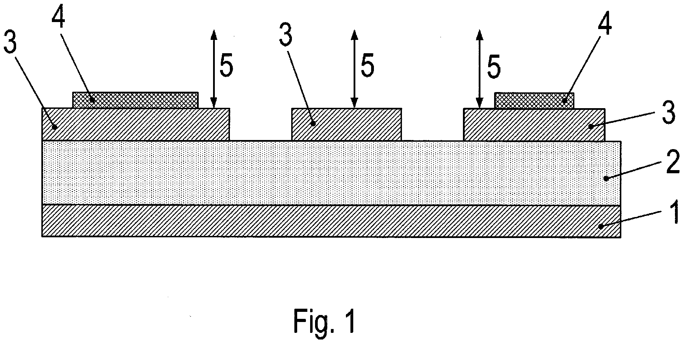

Wie in Figur 1 gezeigt, weist das Leistungsmodul eine Bodenplatte 1 aus Kupfer auf. In einem Elektrogerät, wie Wechselrichter oder Umrichter, wird dieses Leistungsmodul mit seiner Bodenplatte 1 an einen Kühlkörper angedrückt zur Abfuhr von Wärme.

Auf der von dem Kühlkörper abgewandten Seite der Bodenplatte 1 ist eine Isolationsschicht 2 angeordnet, auf deren von der Bodenplatte 1 abgewandten Seite Leiterbahnen 3 angeordnet sind.

Auf den Leiterbahnen 3 sind Halbleiter 4 angeordnet. Dabei ist jeweils ein elektrischer Anschlussbereich des jeweiligen Halbleiters elektrisch verbunden mit einer jeweiligen Leiterbahn 3. Vorzugsweise ist der jeweilige Halbleiter 4 zwischen den Leiterbahnen 3 hängend angeordnet und dabei mit der jeweiligen Leiterbahn lötverbunden oder gesintert verbunden.

Das Leistungsmodul wird mittels Anschlusskontakten elektrisch verbunden mit Leiterbahnen einer gewöhnlichen Leiterplatte. Hierbei sind Federkontakte, Einpresskontakte oder Lötkontakte verwendbar. Der jeweilige Anschlusskontakt ist vorzugsweise angedrückt an einen jeweiligen Bereich der Leiterbahn 3 des Leistungsmoduls.

Auf diese Weise ist eine sichere und leistungsfähige Kontaktierung erreichbar.

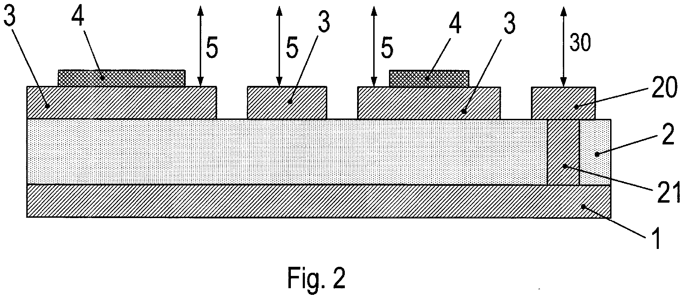

Wie in Figur 2 gezeigt, wird eine Durchkontaktierung 21 in der Isolationsschicht 2 vorgesehen, um eine Potentialausgleichsverbindung, insbesondere Erdung und/oder Nullleiterverbindung, in einfacher Weise realisierbar zu machen.

An der von der Bodenplatte 1 abgewandten Seite der Isolationsschicht 2 ist eine Leiterbahn 20 ausgebildet, welche mit der Durchkontaktierung 21 elektrisch leitend verbunden ist. Dabei ist die Leiterbahn 20 vorzugsweise ringförmig und konzentrisch zur Mittelachse der Durchkontaktierung 21 ausgeführt. Die Durchkontaktierung 21 ist elektrisch leitend mit der Bodenplatte 1 verbunden. Vorzugsweise wird die Durchkontaktierung 21 auf die Bodenplatte 1 gedrückt und somit die elektrische Verbindung bewirkt.

Von der Leiterplatte aus ist auch ein Anschlusskontakt an die Durchkontaktierung 21 und/oder an die Leiterbahn 20 angedrückt, so dass eine Potentialausgleichsverbindung in einfacher Weise realisierbar ist.

Die Isolationsschicht 2 ist aus Keramik gefertigt und somit aus einem elektrisch nicht leitfähigen, also isolationsfähigem, Material, das aber auch mechanisch stabil ist.

Auf diese Weise ist nicht nur ein Potentialausgleich auf dem Leistungsmodul bewirkt, sondern auch eine Verbindung des Potentialausgleichs der Leiterplatte mit dem Kühlkörper, der somit auch mit Erde verbindbar ist.

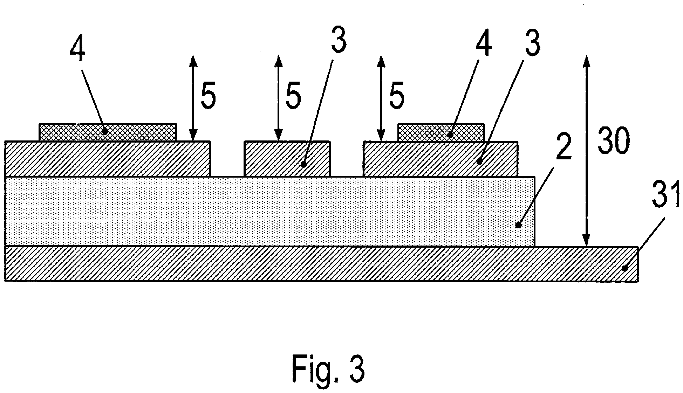

Wie in Figur 3 gezeigt, ist alternativ die Bodenplatte 31 des Leistungsmoduls vergrößert ausführbar. Auf diese Weise ragt die Bodenplatte 31 aus dem restlichen Leistungsmodul hervor, so dass der hervorragende Bereich als Kontaktierung 30 für Potentialausgleichsverbindung verwendbar ist. Außerdem liegt der hervorragende Bereich der Bodenplatte 31 auch am Kühlkörper an und verbessert somit nicht nur die Wärmeaufspreizung des Leistungsmoduls, die Wärmekapazität der Bodenplatte 31 sondern auch den Wärmeübergang von der Bodenplatte 31 zum Kühlkörper hin.

Die Bodenplatte 31 ragt dabei in einer Richtung hervor, welche senkrecht zur Normalenrichtung der Bodenplatte 31 und senkrecht zur Normalenrichtung der Isolationsschicht 2 ausgerichtet ist. Insbesondere ist der von der Bodenplatte 31 überdeckte Flächenbereich, größer als der von der Isolationsschicht 2 überdeckte Flächenbereich. Insbesondere ist also der von der senkrechten Projektion der Bodenplatte überdeckte Flächenbereich größer als der von der senkrechten Projektion der Isolationsschicht überdeckte Flächenbereich. Dabei wird die senkrechte Projektion in eine die Bodenplatte 31 umfassende Ebene ausgeführt, so dass die Normale der Ebene der Normalenrichtung der Bodenplatte 1 entspricht. Die Bodenplatte 1 wir hierzu idealisierend als sehr dünn angesehen.

Die Halbleiter 4 des Leistungsmoduls bilden vorzugsweise einen Gleichrichter und/oder einen Wechselrichter.

Bei Ausführung als Wechselrichter ist besonders bevorzugt ein gleichspannungsseitiger Anschluss des Wechselrichters vorgesehen, aus welchem drei Halbbrücken parallel versorgt werden, deren Mittelanzapfungen jeweils vom wechselspannungsseitigen Anschluss des Wechselrichters umfasst sind.

Somit werden also beim Wechselrichter die drei zueinander parallel geschalteten Reihenschaltungen, welche jeweils zwei in Reihe geschaltete steuerbare Halbleiterschalter aufweisen, aus einer Gleichspannung versorgt. Die Halbleiter sind pulsweitenmoduliert ansteuerbar mit einer Frequenz von 4 kHz oder mehr. Jedem Halbleiter ist vorzugsweise eine Diode parallel zugeschaltet zur Verhinderung von Überspannungen.

Der Gleichrichter ist vorzugsweise als dreiphasiger Brückengleichrichter ausgeführt.

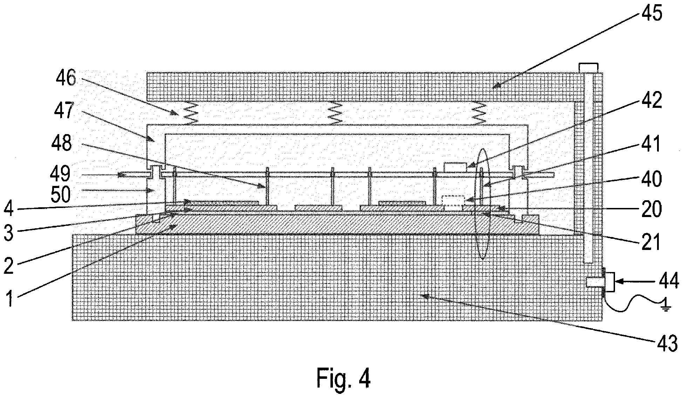

In Figur 4 ist ein weiteres Ausführungsbeispiel gezeigt, wobei dort das Leistungsmodul auf ein metallisches Gussteil 43 des Elektromotors aufgesetzt ist. Auf das Gussteil 43 ist ein Deckelteil 45 aufgesetzt und verbunden, so dass am Gussteil 43 abgestützte Federelemente 46 auf das rahmenteil 47 drücken, welches auf ein Rahmenteil 50 des Leistungsmoduls drückt.

Da das Rahmenteil 50 auf der vom Gussteil 43 abgewandten Seite der Bodenplatte 1 des Leistungsmoduls angeordnet ist, wird somit die Bodenplatte 1 an das Gussteil 43 angedrückt.

Auf der von dem Gussteil 43 abgewandten Seite der metallischen Bodenplatte 1, insbesondere Kupferplatte, ist wiederum eine Isolationsschicht aus 2 Keramik angeordnet, auf der wiederum Leiterbahnen 3 und dort aufgesetzte und lötverbundene oder angesinterte Halbleiter 4 angeordnet sind.

Außerdem ist auf Leiterbahnen 3 des Leistungsmoduls auch ein Kondensator 40, insbesondere ein Y-Kondensator, angeordnet, welcher mittels seines ersten Pols mit der Leiterbahn 20 für Potentialausgleichsverbindung elektrisch verbunden ist. Mit dem anderen Pol ist er mit dem Mittelabgriff einer Reihenschaltung verbunden, die aus zwei Kondensatoren, insbesondere zwei X-Kondensatoren, gebildet ist, wobei die Reihenschaltung aus einer Zwischenkreisspannung des den Elektromotor speisenden Umrichters gespeist ist. Somit bilden die Kondensatoren eine Entstöreinheit, welche im Leistungsmodul angeordnet ist und somit nur kurze Wege zu den Störquellen, also den Halbleitern 4, aufweist. Als Halbleiter 4 sind nämlich steuerbare Halbleiterschalter, insbesondere pulsweitenmoduliert ansteuerbare steuerbare Halbleiterschalter, verwendet.

Die Leiterplatte 49 weist Kontakte (41, 48) auf, welche angedrückt sind an Leiterbahnen (3, 20).

Alternativ oder zusätzlich sind auch auf der Leiterplatte 49 Kondensatoren 42 einer Entstöreinheit anordenbar. Dabei ist der Kontakt 41 für die Potentialausgleichsverbindung zur Leiterbahn 20 zuständig, welche mittels einer Durchkontaktierung 21 mit der Bodenplatte 1 verbunden ist, welche direkt auf das Gussteil 43 gedrückt ist, welches einen Erdungsanschluss 44 aufweist und dort mit elektrisch Erde verbunden ist, also elektrisch geerdet ist.

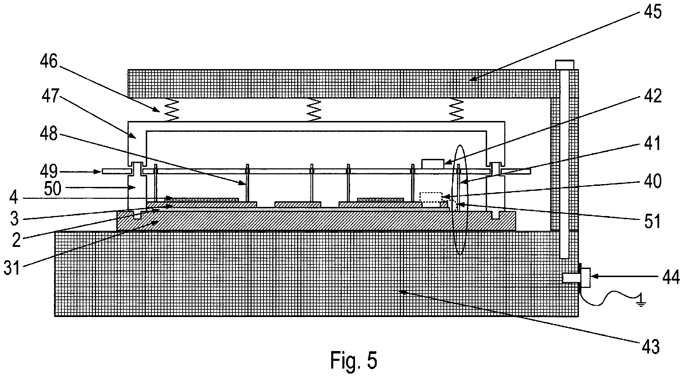

In Figur 5 ist ein weiteres Ausführungsbeispiel gezeigt, das im Unterschied zur Figur 4 eine direkte Kontaktierung 30 der Bodenplatte entsprechend der Ausführung gemäß Figur 3 aufweist. Der Kontakt 41 wird hierbei also auf die Bodenplatte 1 gedrückt und nicht auf eine Leiterbahn des Leistungsmoduls.

Die mit der Entstöreinheit, insbesondere also mit dem Kondensator 40, verbundene Leiterbahn ist mittels eines Bonddrahtes 51 mit der Bodenplatte verbunden.

### Bezugszeichenliste

1 Bodenplatte
2 Isolationsschicht
3 Leiterbahn
4 Halbleiter
5 Kontaktierung durch Anschlusskontakte
20 Leiterbahn für Potentialausgleichsverbindung
21 Durchkontaktierung
30 Kontaktierung für Potentialausgleichsverbindung
31 Bodenplatte, insbesondere verlängert
40 Kondensator einer Entstöreinheit
41 Kontakt, insbesondere Pin
42 Kondensator einer weiteren Entstöreinheit
43 metallisches Gussteil des Elektromotors
44 Erdungsanschluss
45 Deckelteil
46 Federelement
47 Rahmenteil
48 Kontakt, insbesondere Pin
49 Leiterplatte
50 Rahmenteil des Leistungsmoduls
51 Bonddraht

## Patentansprüche

1. Elektronische Anordnung mit Leistungsmodul, Leiterplatte und Kühlkörper,
wobei
das Leistungsmodul eine metallische Bodenplatte (1) aufweist,
wobei eine Isolationsschicht (2) an der der Leiterplatte zugewandten Seite der Bodenplatte angeordnet ist,
wobei an der von der Bodenplatte abgewandten Seite der Isolationsschicht metallische Leiterbahnen, insbesondere aus Kupfer, angeordnet sind,
wobei Halbleiter (4) auf den Leiterbahnen angeordnet sind auf der von der Isolationsschicht jeweils abgewandten Seite der Leiterbahnen,
wobei die Bodenplatte direkt oder mittels einer Durchkontaktierung mit einem zur Leiterplatte als Potentialausgleich fungierenden Anschlusskontakt verbindbar ist,
wobei der als Potentialausgleich fungierende Anschlusskontakt Erdpotential aufweist, insbesondere wobei die Bodenplatte aus Kupfer ist,
wobei das Leistungsmodul eine kapazitive Störströme kurzschließende Entstöreinheit aufweist,
**dadurch gekennzeichnet, dass**
die Entstöreinheit drei Kondensatoren aufweist, wobei ein erster der drei Kondensatoren mit seinem ersten Pol elektrisch mit dem als Potentialausgleich fungierenden Anschlusskontakt verbunden ist und als Y-Kondensator (40) ausgeführt ist,
wobei die beiden anderen Kondensatoren als X-Kondensatoren ausgeführt sind und in Reihe geschaltet und aus einer Gleichspannungsquelle versorgt sind,
wobei der Y-Kondensator (40) mit seinem anderen Pol elektrisch verbunden ist mit einem Mittelabgriff der Reihenschaltung der beiden X-Kondensatoren,
wobei die Gleichspannungsquelle die Zwischenkreisspannung eines Umrichters ist,
wobei der erste Pol des Y-Kondensators (40) einer Leiterbahn (3) des Leistungsmoduls verbunden ist, welche mittels eines Bonddrahtes mit der Bodenplatte (1) verbunden ist.

2. Anordnung nach Anspruch 1,
**dadurch gekennzeichnet, dass**
die Bodenplatte an einen Kühlkörper angedrückt ist, insbesondere mit ihrem von der Isolationsschicht abgewandten Seite.

3. Anordnung nach mindestens einem der vorangegangenen Ansprüche,
**dadurch gekennzeichnet, dass**
der Anschlusskontakt ein Druckkontakt, ein Federkontakt, ein Lötkontakt oder ein Einpresskontakt ist.

4. Anordnung nach mindestens einem der vorangegangenen Ansprüche,
**dadurch gekennzeichnet, dass**
der Anschlusskontakt mit der Leiterplatte mechanisch und elektrisch verbunden ist.

5. Anordnung nach mindestens einem der vorangegangenen Ansprüche,
**dadurch gekennzeichnet, dass**
der Anschlusskontakt
- an die Bodenplatte oder
- an eine Durchkontaktierung oder
- an eine auf der Isolationsschicht angeordnete Leiterbahn, welche mit einer mit der Bodenplatte elektrisch verbundenen Durchkontaktierung verbunden ist,
angedrückt gehalten ist.

6. Anordnung nach mindestens einem der vorangegangenen Ansprüche,
**dadurch gekennzeichnet, dass**
die Bodenplatte den Kühlkörper berührt,
wobei die Berührfläche zwischen Bodenplatte und Kühlkörper eben ist, insbesondere also von einer Ebene umfasst ist,
wobei der von der senkrechten Projektion der Bodenplatte in die Ebene überdeckte Flächenbereich größer ist als der von der senkrechten Projektion der Isolationsschicht in die Ebene überdeckte Flächenbereich.

7. Anordnung nach mindestens einem der vorangegangenen Ansprüche,
**dadurch gekennzeichnet, dass**
ein an einem mit dem Kühlkörper verbundenen Gehäuseteil der Anordnung abgestütztes Federelement die Leiterplatte an das Leistungsmodul mittels der Anschlusskontakte andrückt,
insbesondere so, dass das Leistungsmodul auf den Kühlkörper gedrückt wird.

8. Anordnung nach mindestens einem der vorangegangenen Ansprüche,
**dadurch gekennzeichnet, dass**
die Isolationsschicht aus Keramik, insbesondere Korund und/oder einem Aluminiumoxid enthaltenden Stoffgemisch, gefertigt ist.

9. Anordnung nach mindestens einem der vorangegangenen Ansprüche,
**dadurch gekennzeichnet, dass**
die Leiterplatte mit Bauelementen einer Signalelektronik bestückt ist, welche Ansteuersignale für steuerbare Halbleiter des Leitungsmoduls erzeugt.

10. Anordnung nach mindestens einem der vorangegangenen Ansprüche,
**dadurch gekennzeichnet, dass**
die Anordnung ein Wechselrichter oder ein Umrichter ist, welcher einen Elektromotor speist,
und/oder wobei der Kühlkörper ein Teil des Elektromotors ist, insbesondere eine Lüfterhaube des Elektromotors.

11. Anordnung nach mindestens einem der vorangegangenen Ansprüche,
**dadurch gekennzeichnet, dass**
das Leistungsmodul zur elektrischen Kontaktierung vorgesehene Leiterbahnen aufweist, welche eine Netzphase, eine Motorphase, ein Zwischenkreispotential, ein Ansteuersignal und/oder ein Brems-Chopper-Potential führen.

## Claims

1. Electronic assembly comprising power module, circuit board and heat sink,
wherein the power module has a metal base plate (1),
wherein an insulation layer (2) is arranged on the side of the base plate facing towards the circuit board,
wherein metal conductor tracks, in particular made of copper, are arranged on the side of the insulation layer facing away from the base plate,
wherein semiconductors (4) are arranged on the conductor tracks on the side of the conductor tracks facing away from the insulation layer,
wherein the base plate can be connected directly or by means of a via to a connection contact that acts as an equipotential bond to the circuit board,
wherein the connection contact that acts as an equipotential bond is at ground potential,
in particular wherein the base plate is made of copper, wherein the power module has an interference suppression unit which short-circuits capacitive interference currents, **characterized in that** the interference suppression unit has three capacitors,
wherein a first of the three capacitors is electrically connected by its first pole to the connection contact that acts as an equipotential bond, and is designed as a Y capacitor (40), wherein the other two capacitors are designed as X capacitors and are connected in series and are supplied from a DC voltage source,
wherein the Y capacitor (40) is electrically connected by its other pole to a centre tap of the series connection of the two X capacitors,
wherein the DC voltage source is the DC link voltage of a converter,
wherein the first pole of the Y capacitor (40) is connected to a conductor track (3) of the power module, which conductor track is connected to the base plate (1) by means of a bond wire.

2. Assembly according to claim 1,
**characterized in that**
the base plate is pressed against a heat sink, in particular with its side facing away from the insulation layer.

3. Assembly according to at least one of the preceding claims, **characterized in that**
the connection contact is a pressure contact, a spring contact, a solder contact or a press-fit contact.

4. Assembly according to at least one of the preceding claims, **characterized in that**
the connection contact is mechanically and electrically connected to the circuit board.

5. Assembly according to at least one of the preceding claims, **characterized in that**
the connection contact is kept pressed against
- the base plate or
- a via or
- a conductor track arranged on the insulation layer, which conductor track is connected to a via that is electrically connected to the base plate.

6. Assembly according to at least one of the preceding claims, **characterized in that**
the base plate is in contact with the heat sink,
wherein the contact surface between the base plate and the heat sink is flat, in particular is encompassed by a plane,
wherein the surface area covered by the perpendicular projection of the base plate into the plane is larger than the surface area covered by the perpendicular projection of the insulation layer into the plane.

7. Assembly according to at least one of the preceding claims, **characterized in that**
a spring element supported against a housing part of the assembly connected to the heat sink presses the circuit board against the power module by means of the connection contacts,
in particular such that the power module is pressed onto the heat sink.

8. Assembly according to at least one of the preceding claims, **characterized in that**
the insulation layer is made of ceramic, in particular corundum and/or a substance mixture containing aluminium oxide.

9. Assembly according to at least one of the preceding claims, **characterized in that**
the circuit board is equipped with components of a signal electronics system which generates actuation signals for controllable semiconductors of the power module.

10. Assembly according to at least one of the preceding claims, **characterized in that**
the assembly is an inverter or a converter which powers an electric motor,
and/or wherein the heat sink is part of the electric motor, in particular a fan cover of the electric motor.

11. Assembly according to at least one of the preceding claims, **characterized in that**
the power module has conductor tracks provided for electrical contacting, which conductor tracks conduct a mains phase, a motor phase, a DC link potential, an actuation signal and/or a brake chopper potential.

## Revendications

1. Ensemble électronique comprenant un module d'alimentation, une carte de circuit imprimé et un dissipateur thermique,
le module d'alimentation comportant une plaque de base métallique (1),
une couche isolante (2) étant disposée sur le côté de la plaque de base qui est dirigé vers la carte de circuit imprimé,
des pistes conductrices métalliques, notamment en cuivre, étant disposées du côté de la couche isolante qui est opposé à la plaque de base,
des semi-conducteurs (4) étant disposés sur les pistes conductrices du côté des pistes conductrices qui est opposé à la couche isolante,
la plaque de base pouvant être reliée, directement ou au moyen d'un contact traversant, à un contact de connexion fonctionnant comme une compensation de potentiel par rapport à la carte de circuit imprimé,
le contact de connexion, fonctionnant comme une compensation de potentiel, présentant un potentiel de masse, en particulier la plaque de base étant en cuivre, le module de puissance comportant une unité d'antiparasitage court-circuitant des courants parasites capacitifs,
**caractérisé en ce que** l'unité d'antiparasitage comporte trois condensateurs,
un premier des trois condensateurs étant relié électriquement au niveau de son premier pôle au contact de connexion fonctionnant en compensation de potentiel et étant conçu comme un condensateur Y (40),
les deux autres condensateurs étant conçus comme des condensateurs X et étant montés en série et alimentés par une source de tension continue,
le condensateur Y (40) étant relié électriquement au niveau de son autre pôle à une prise centrale du montage en série des deux condensateurs X,
la source de tension continue étant la tension de circuit intermédiaire d'un convertisseur,
le premier pôle du condensateur Y (40) étant relié à une piste conductrice (3) du module de puissance, laquelle est reliée à la plaque de base (1) au moyen d'un fil de liaison.

2. Ensemble selon la revendication 1,
**caractérisé en ce que**
la plaque de base est pressée contre un dissipateur thermique, en particulier avec son côté opposé à la couche isolante.

3. Ensemble selon l'une au moins des revendications précédentes,
**caractérisé en ce que**
le contact de connexion est un contact de pression, un contact à ressort, un contact à souder ou un contact à enfoncer.

4. Ensemble selon l'une au moins des revendications précédentes,
**caractérisé en ce que**
le contact de connexion est relié mécaniquement et électriquement à la carte de circuit imprimé.

5. Ensemble selon l'une au moins des revendications précédentes,
**caractérisé en ce que**
le contact de connexion est maintenu pressé
- contre la plaque de base ou
- contre un contact traversant ou
- contre une piste conductrice disposée sur la couche isolante et reliée à un contact traversant relié électriquement à la plaque de base.

6. Ensemble selon l'une au moins des revendications précédentes,
**caractérisé en ce que**
la plaque de base est en contact avec le dissipateur thermique,
la surface de contact entre la plaque de base et le dissipateur thermique est plane, c'est-à-dire en particulier est située dans un plan,
la zone de surface couverte par la projection verticale de la plaque de base dans le plan étant plus grande que la zone de surface couverte par la projection verticale de la couche isolante dans le plan.

7. Ensemble selon l'une au moins des revendications précédentes,
**caractérisé en ce que**
un élément à ressort supporté en appui sur une partie de boîtier de l'ensemble reliée au dissipateur thermique presse la carte de circuit imprimé contre le module de puissance au moyen des contacts de connexion,
notamment pour que le module de puissance soit pressé sur le dissipateur thermique.

8. Ensemble selon l'une au moins des revendications précédentes,
**caractérisé en ce que**
la couche isolante est en céramique, notamment en corindon et/ou en un mélange de substances contenant de l'oxyde d'aluminium.

9. Ensemble selon l'une au moins des revendications précédentes,
**caractérisé en ce que**
la carte de circuit imprimé est équipée de composants d'une électronique de signal qui génère des signaux de commande destinés aux semi-conducteurs commandables du module de puissance.

10. Ensemble selon l'une au moins des revendications précédentes,
**caractérisé en ce que**
l'ensemble est un onduleur ou un convertisseur qui alimente un moteur électrique,
et/ou le dissipateur thermique étant une partie du moteur électrique, en particulier un capot de ventilateur du moteur électrique.

11. Ensemble selon l'une au moins des revendications précédentes,
**caractérisé en ce que**
le module de puissance comporte des pistes conductrices qui sont prévues pour le contact électrique et qui conduisent une phase de réseau, une phase de moteur, un potentiel de circuit intermédiaire, un signal de commande et/ou un potentiel de hacheur de freinage.
